# EUROPEAN PATENT SPECIFICATION

(11) **EP 2 779 205 B1**
(45) Date of publication and mention of the grant of the patent: **18.10.2017**
(21) Application number: 13159526.6
(22) Date of filing: 15.03.2013
(51) Int. Cl.: H01J 37/147, H01F 41/04, H01J 37/14, H01F 5/00

(54) **High throughput scan deflector and method of manufacturing thereof**
Scan-Deflektor mit hohem Durchsatz und Herstellungsverfahren dafür
Déflecteur de balayage à débit élevé et son procédé de fabrication

(43) Date of publication of application: 17.09.2014
(73) Proprietor: ICT Integrated Circuit Testing Gesellschaft für Halbleiterprüftechnik mbH, 85551 Heimstetten (DE)
(72) Inventor: Adamec, Pavel, 85540 Haar (DE)
(74) Representative: Zimmermann & Partner Patentanwälte mbB

(56) References cited:
- US-A- 3 702 450
- US-A- 5 264 706
- US-A- 5 753 922
- US-A- 6 153 885
- US-A1- 2011 036 810

## Description

### TECHNICAL FIELD OF THE INVENTION

Embodiments of the present invention relate to magnetic scanning in scanning electron microscopes (SEMs). They relate to scanning deflector assemblies, magnetic deflectors, and wafer imaging systems with such scanning deflector assemblies. Specifically, they relate to wafer imaging systems, wafer SEM imaging apparatuses, and to methods relating to scan deflectors for a wafer SEM imaging apparatus.

### BACKGROUND OF THE INVENTION

Charged particle beam apparatuses have many functions, in a plurality of industrial fields, including, but not limited to, critical dimensioning of semiconductor devices during manufacturing, defect review of semiconductor devices during manufacturing, inspection of semiconductor devices during manufacturing, exposure systems for lithography, detecting devices and testing systems. Thus, there is a high demand for structuring, testing and inspecting specimens within the micrometer and nanometer scale.

Micrometer and nanometer scale process control, inspection or structuring is often done with charged particle beams, e.g. electron beams, which are generated and focused in charged particle beam devices, such as electron microscopes or electron beam pattern generators. Charged particle beams offer superior spatial resolution compared to, e.g. photon beams due to their short wavelengths.

For scanning of an electron beam, e.g. in SEM based wafer inspection tools, electric or magnetic fields can be used. An electric field can be created by arrangement of electrodes. A magnetic field can be generated by an arrangement of coils. According to the generally accepted option, magnetic deflection is considered not to be able to achieve as high scanning speeds and accuracy as the electric deflector. However magnetic deflectors have some advantages in practical application, like lower sensitivity to contamination, lower aberrations, and easier implementation. Accordingly, it is desirable to provide a magnetic deflector system having the advantages of the traditional magnetic system, but overcome the limitations in the scanning speed and accuracy. US 3,702,450 relates to steering coils for deflecting moving charged particle beams. Rectangular spiral coils are formed on a printed circuit board. The printed circuit board is drilled through for connection, and the coils are arranged in series connection, beginning at an input electrical lead and ending at an output electrical lead. The steering coils may have 0.004 inch (0.1 mm) copper turns. US 5,753,922 describes an electromagnetic deflector for a scanning electron microscope. The electromagnetic deflector includes two coils each with two termini, wherein each coil is embedded in an insulating cylinder.US 6,153,885 relates to deflector coil structures in charged particle beam projection systems employed in lithography. A deflector includes a hub supporting deflection coil vanes. A deflection coil vane includes a substrate with coils on both sides of the substrate, the coils being wound as planar spirals and being interconnected.

In view of the above, it is an object of the present invention to provide an improved scan deflector for a wafer imaging apparatus, and an improved wafer imaging apparatus that would overcome at least some of the above problems.

### SUMMARY OF THE INVENTION

According to one embodiment, a magnetic deflector assembly configured for scanning a primary electron beam, and particularly for providing an upgrade kit for a wafer imaging systems, is provided. The magnetic deflector assembly includes at least one magnetic deflector for scanning the beam over a wafer in one direction, wherein the at least one magnetic deflector comprises at least four coils forming a pair of the at least two coil units, wherein the number of turns in each of the at least four coils is 8 or less and wherein the maximum dimension of a cross-section of a coil-forming wire or of a coil forming conductor is 0.2 mm or less. The number of coils in each coil unit is two or more. According to the invention, the magnetic deflector assembly is characterised in that each of the two or more coils in each coil unit is formed by a multiple wire string.

According to another embodiment, a wafer imaging system configured for imaging a wafer is provided. The system includes an emitter having an emitter tip adapted for providing an electron beam, an objective lens configured for focusing the electron beam on the wafer, at least one condenser lens provided between the emitter tip and the objective lens and magnetic scanning deflector assembly as described herein for scanning the electron beam over the wafer to generate the image of the wafer.

According to a yet further embodiments, a method of manufacturing a magnetic deflector assembly for scanning the electron beam over the wafer to generate the image of the wafer is provided. The method includes providing at least two coils wherein the number of turns in the at least two coils is 8 or less and wherein a maximum dimension of a cross-section of a coil-forming wire or of a coil-forming conductor is 0.2 mm or less, forming a pair of coil units from the at least two coils, forming at least one magnetic deflector for scanning the beam over the wafer in one direction from the pair of coil units. The number of coils in each coil unit is 2 or more. According to the invention, each of the 2 or more coils in each coil unit is formed by a multiple wire string. According to optional implementations, the coil-forming wire or coil-forming conductor is formed by a process selected from the group consisting of: etching, patterning of a conductive foil, screen printing, masked layer deposition, and combinations thereof.

### BRIEF DESCRIPTION OF THE DRAWINGS

So that the manner in which the above recited features of the present invention can be understood in detail, a more particular description of the invention, briefly summarized above, may be had by reference to embodiments. The accompanying drawings relate to embodiments of the invention and are described in the following:
FIG. 1 illustrates a schematic partial view of a retarding field scanning charged particle beam device with a scan deflector according to embodiments described herein;
FIGS. 2A and 2B illustrate schematic views of a scan deflector assembly or a component of a scan deflector assembly according to typical embodiments described herein;
FIGS. 3A and 3B illustrate further schematic views scan deflector assembly or a component of a scan deflector assembly according to typical embodiments described herein;
FIG. 4 illustrates a schematic view of a retarding field scanning charged particle beam device according to embodiments described herein;
FIG. 5 illustrates a schematic view of a retarding field scanning charged particle beam device having two or more beams according to embodiments described herein;
FIG. 6 illustrates a method of operating a retarding field scanning charged particle beam device according to embodiments described herein; and
FIG. 7 illustrates a method of manufacturing a magnetic deflector assembly according to embodiments described herein.

### DETAILED DESCRIPTION OF EMBODIMENTS

Reference will now be made in detail to the various embodiments of the invention, one or more examples of which are illustrated in the figures. Within the following description of the drawings, the same reference numbers refer to same components. Generally, only the differences with respect to individual embodiments are described. Each example is provided by way of explanation of the invention and is not meant as a limitation of the invention. Further, features illustrated or described as part of one embodiment can be used on or in conjunction with other embodiments to yield yet a further embodiment. It is intended that the description includes such modifications and variations.

Without limiting the scope of protection of the present application, in the following the charged particle beam device or components thereof will exemplarily be referred to as an electron beam device including the detection of secondary electrons. The present invention can still be applied for apparatuses and components detecting corpuscles such as secondary and/or backscattered charged particles in the form of electrons or ions, photons, X-rays or other signals in order to obtain a specimen image. Generally, when referring to corpuscles they are to be understood as a light signals in which the corpuscles are photons as well as particles, in which the corpuscles are ions, atoms, electrons or other particles.

A "specimen" or "wafer" as referred to herein, includes, but is not limited to, semiconductor wafers, semiconductor workpieces, and other workpieces such as memory disks and the like. Embodiments of the invention may be applied to any workpiece on which material is deposited or which are structured. A specimen or wafer includes a surface to be imaged and/or structured or on which layers are deposited, an edge, and typically a bevel. According to some embodiments, which can be combined with other embodiments described herein, the apparatus and methods are configured for or are applied for electron beam inspection (EBI), critical dimensioning and defect review applications, where the microscopes and methods according to embodiments described herein, can be beneficially used in light of the desires for high throughput of these applications.

In the context of the here described embodiments, without limiting the scope of protection thereto, an intermediate beam acceleration system intends to describe a charged particle beam apparatus with initial high acceleration of the charged particles which will be decelerated to a landing energy shortly before striking the specimen or wafer. The energy or velocity ratio v_{ac}/v_{landing} between the acceleration velocity v_{ac} at which the charged particles are guided through the column and the landing velocity v_{landing} at which the charged particles strikes the specimen can be about at least 5 or higher. Furthermore, the landing energy can be 2 kV or less. These are approximate values which might be adapted according to circumstances.

Furthermore, in the following description, it is referred to scanning electron beam microscopes (SEM), which can particularly profit from the embodiments described herein. For embodiments described herein and relating to magnetic deflection or scanning, utilization for electron beams is particularly useful.

According to some embodiments described herein, an E-beam inspection (EBI), critical dimensioning (CD) tool, and/or defect review (DR) tool can be provided, wherein high resolution, large field of view, and high scanning speed can be achieved.

Embodiments described herein refer to scan deflector arrangements, scan deflectors, methods of manufacturing such deflectors and SEM imaging systems, where the benefits of magnetic deflection are maintained and at least some of the drawbacks of magnetic deflection in SEM imaging system are overcome or reduced. Accordingly, a magnetic deflection with high speed, good linearity and accuracy can be provided, particularly for wafer SEM inspection tools.

According to embodiments described herein, a wafer imaging system or a wafer SEM inspection tool refers to EBI tools, CD tools, DR tools, which are specific tools as understood by a person skilled in the art.

According to embodiments described herein, a magnetic deflector is provided that includes one pair of coil units for deflection in one direction, e.g. an x-direction. Typically, a deflector arrangement is provided by two magnetic deflectors, i.e. two pairs of coil units, wherein one deflector is provided for x-direction and the other deflector is provided for y-direction. According to yet further embodiments, which can be combined with other embodiments described herein, also four to six magnetic deflectors, i.e. 4 to 6 pairs of coil units that is at least 8 coil units can be provided in one plane. Thereby, the homogeneity for the deflection in a plane (X-Y-plane) can be improved. Yet further, such an arrangement could also be used as a stigmator.

According to typical embodiments, each pair of coil units is formed by at least two individual coils, wherein each coil unit includes at least one coil. Typically, the two coil units or the pair of coil units symmetrically arranged around an optical axis along which the primary electron beam in the SEM tool propagates. According to yet further implementation, each of the two coil units in the pair of coil units may also include two or more coils. For example, a pair of two coil units, wherein each coil unit includes two coils results in four coils. According to typical embodiments, the pair of coil units are symmetrically arranged, e.g. around the optical axis. Thus, in the above example referring to four coils, two coils are provided on one side of the optical axis and two coils are provided on an opposing side of the optical axis.

Typically, each coil can be formed by several turns of a wire, such as a copper wire. It has been found that the design of the coils can be improved to achieve the desired scanning performance, linearity and accuracy. Thus, the invention could disprove the generally accepted opinion that magnetic coil system cannot give satisfactory performance at high scanning speeds.

According to one embodiment, a coil for a magnetic deflector for an SEM inspection tool is provided wherein the number of turns is 8 or below and wherein the cross-section of the wire or conductor of the coil has a dimension of 0.2 mm or less. Thereby, typically, the dimension can be the diameter of a round wire or conductor. For rectangular wires or conductors, the dimension is the dimension perpendicular to the magnetic field generated by the coils of the magnetic deflector. Typically or often this will be the larger dimension of the rectangular cross-section. It is understood, that depending on the manufacturing method of the wire or the conductor forming the wire of the coil, a deviation from a rectangular shape in a mathematical sense can occur.

Accordingly, in light of the above the dimension being 0.2 mm or less can be selected from the group consisting of: the maximum dimension, the dimension perpendicular to the magnetic field generated by the magnetic deflector, and the dimension perpendicular to the surface of the support of the coil.

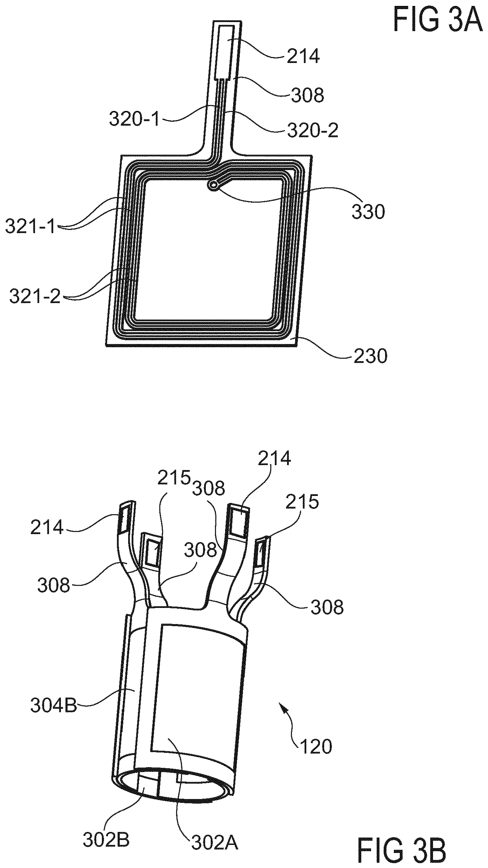

According to typical embodiments, a magnetic deflector for one deflection direction typically has at least one pair of coils according to embodiments described herein. A magnetic deflector arrangement including two magnetic deflectors, each for one direction, has, thus, at least two pairs of the coil units according to embodiments described herein. Yet further, as will be described in more detail with respect to FIG. 3B below, a magnetic deflector for one scan direction can have a pair of a set of coils, i.e. a first set of coils and a second set of coils. Each pair of a set of coils forms a coil unit, such that a pair fo coil units can be provided. The pair of a plurality of coils or set of coils is typically arranged symmetrically with respect to the optical axis.

The beam is scanned by a deflector or a deflector arrangement over a surface of the specimen or wafer. According to typical embodiments, the magnetic deflectors are configured for e.g. scanning of lines, particularly for high scanning speeds, e.g. pixel rates of 100 MHz or above or even in the GHz region and line speeds of 100 kHz or above or even in the MHz region. Accordingly, the scan deflector arrangements can be connected to or can include one or more power supplies for providing AC currents with the desired high frequencies

Further, embodiments relate to retarding field microscopes, e.g. low-voltage high-resolution SEM's, where a low landing energies of the primary beam (e.g. 2 keV or below such as 1 keV or below) is used to limit the load on the sample and to avoid damage. Thereby, in order to achieve small beam diameters for maximum resolution, the beam is guided through the microscope column at high energies. Accordingly, a scanning electron microscope with intermediate beam acceleration can be used, where the electron beam is extracted from the source and accelerated to a high energy, e.g. 20kV or more. In the final objective lens the beam is slowed down to the required low landing energy of e.g.1 kV or less.

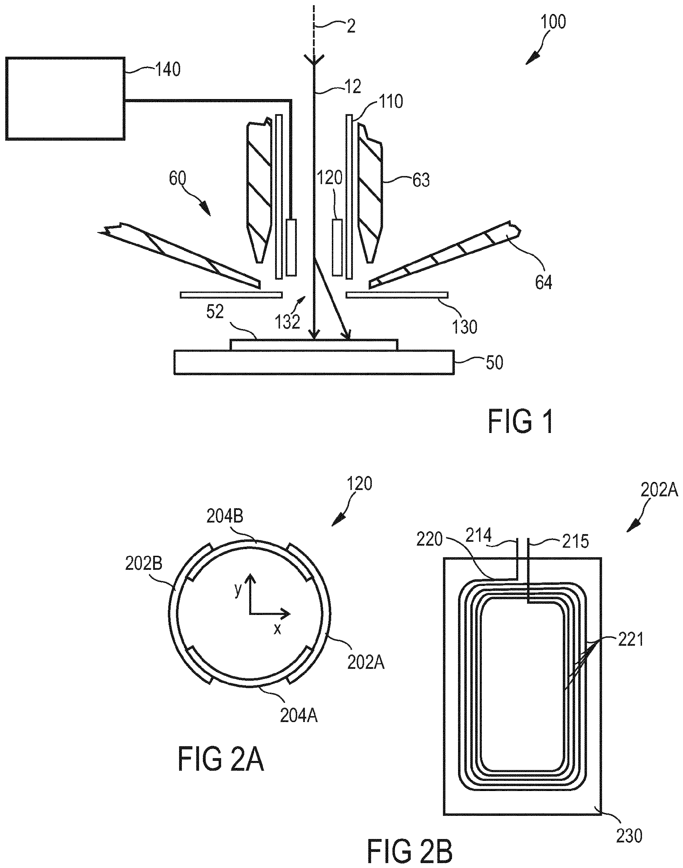

According to some embodiments described herein, the final objective lens for an electron beam system includes a magnetic-electrostatic lens. As shown in FIG. 1, the latter consists typically of an upper electrode, which lies on a high potential in reference to the primary electrons, and a lower electrode, which lies on a potential close to the sample voltage. These electrodes contribute to focusing, as well as to slowing down the beam to the required low primary beam voltage. This kind of immersion lens allows focusing the beam with minor loss of resolution compared to high beam voltage systems.

FIG. 1 shows a portion of a scanning electron microscope 100. The objective lens 60 includes the magnetic lens portion having an upper pole piece 63, a lower pole piece 64 and a coil (not shown in FIG. 1). The objective lens 60 further includes an electrostatic lens portion having a first electrode 110, i.e. upper electrode in the figures, and a second electrode 130, i.e. lower electrode in the figures.

The objective lens 60 focuses the electron beam 12, which travels in the column along optical axis 2, on the specimen 52, i.e. in a specimen plane. The specimen 52 is supported on a specimen support table 50. According to some embodiments, which can be combined with other embodiments described herein, scanning of an area of the specimen can be conducted by movement of the table in a first direction essentially perpendicular to the optical axis and by scanning lines in another, second direction essentially perpendicular to the optical axis and essentially perpendicular to the first direction.

If the beam is scanned according to a predetermined scan pattern, e.g. adjacent lines are scanned, the beam travels off the optical axis 2 in order to scan the required field-of-view. Thereby, a magnetic scanning deflector assembly 120 according to embodiments described herein is used. Typically, at least one scanning direction essentially perpendicular to the optical axis 2 (e.g. z-direction) is provided. Often two scanning directions (e.g. x-direction and y-direction) and the corresponding scanning assembly with more than on scanning deflector are provided. The one or more scanning deflectors are thereby configured for high speed scanning, e.g. to achieve a pixel rate in the GHz region (e.g. 3 GHz or above) and/or a line rate in the MHz region (e.g. 3 MHz or above).

According to embodiments described herein, the scan deflector assembly 120 is connected to a controller 140 or a controller assembly to provide the currents to the coils for high speed scanning. According to typical embodiments, which can be combined with other embodiments, the frequency of the AC current provided by the controller to the magnetic deflector coil is 0.1 MHz to 10 MHz. Due to the embodiments described herein, a deviation from the linearity can be at about 0.1 % or below for the speed scanning. Yet, it is obvious that such values might depend on the actually scanning speed.

The embodiments described herein have a limited number of turns in the coil, which is, however, sufficient for the needs in SEM inspection tools having the coils as described herein. Accordingly, a high inductance, which would increase with the number of turns to the power of two, can be avoided. Further, the limited maximum dimension of the wire or conductor reduces currents induced in a portion of wire or conductor of the coil itself, which could be induced by the generated magnetic field.

FIG. 2A shows a scanning deflector assembly 120. The scanning deflector assembly includes a first pair of coil units 202A and 202B, wherein at least one coil is provided on or within each of the elements 202A and 202B. The first pair of coil units provides a magnetic field in x-direction. It can be shaped and arranged to provide a homogeneous magnetic field in the center at the optical axis of the electron beam. The magnetic field in x-direction deflects the beam in y-direction for scanning in y-direction. The scanning deflector assembly further includes a second pair of coil units 204A and 204B, wherein at least on coil is provided on or within each of the coil units 204A and 204B. The second pair of coil units provides a magnetic field in y-direction. It can be shaped and arranged to provide a homogeneous magnetic field in the center at the optical axis of the electron beam. The magnetic field in y-direction deflects the beam in x-direction for scanning in x-direction. Due the combination of the two directions, an arbitrary deflection in the x-y-plane can be realized.

As shown on FIG. 2A each of the two deflectors with coil units 202A/B or 204A/B, respectively, are provided on a circle. The two circles are typically concentric. However, according to other embodiments, the coil units can also be provided as substantially flat elements, such that a square or rectangle is provided by the four coil units shown in FIG. 2A. Typically, the shape can be curved or flat. The shape is configured to provide a homogeneous magnetic field at the center of the assembly 120 in order to have a homogeneous field for deflection of an electron beam on the optical axis.

FIG. 2B illustrates a coil units 202A, which is shown to be flat in FIG. 2B for exemplary purposes only. The coil units could also be bended as shown in FIG. 2A. Further, one of the coil units shown in FIG. 2A is exemplarily shown. The coil unit 202A includes a support 230. A wire 220 or a conductor is provided on the support in the form of coil. Thereby, a current can be applied by first connector 214 and second connector 215, which can be connected to a controller for providing an AC current for scanning. The coils shown in FIG. 2B includes 5 turns 221. According to typical embodiments, which can be combined with other embodiments described herein, the number of turns is 8 or less.

According to yet further embodiments, which can be combined with other embodiments described herein, the support 230 can include a magnetically soft material with a high electrical resistivity. According to a typical implementation, the support can thereby be provided, such that the support is provided on side of the coil opposing the side facing the optical axis. That is the coil is between the magnetically soft material and the optical axis. In the Example shown in FIG. 2A, and according to some further embodiments, which can be combined with other embodiments described herein, the magnetically soft material can for example be provided in the form of a ring. The ring can surround the coil units 202-204. The ring can also be partly or fully provided by the support 230 of one or more of the coil units.

As shown in FIG. 3A, one or more coils can also be provided on a support 230 as follows. According to the invention as claimed, which can be combined with other embodiments described herein, a multiple wire string is provided. The multiple wire string can also be referred to as a lamination. Typically, the number of wires in a string can be from 2 to 10, e.g. 2 to 6. FIG. 3A shows a wire or conductor 320-1 and a wire or conductor 320-2. Both wires or conductors are connected to a connector 214. As shown in FIG. 3A, two turns 321-1 and 321-2 can be provided on one side of the support 320. A through connect 330 through the support 230 can be provided. Thereby, for example, two further turns can be provided on the opposing side (the back side in FIG. 3A) of the support. The further turns of the two wires or conductors 320-1 and 320-2, which are provided on the back side are connected to a further connector on the opposing side (the back side in FIG. 3A) of the support.

Accordingly, the example shown in FIG. 3A and considering the back side of the support 230 has four turns of a wire string with two wires. As described above, and according to embodiments, which can be combined with other embodiments described herein, the wires, e.g. wires 320-1 and 320-2 in FIG. 3A have a cross-section with a maximum dimension of 0.2 mm or less, such as 0.1 mm. Due to the utilization of a wire string or lamination with "2 to 10 wires, for example 2, 3, 4 or 6 wires, the maximum current can be increased while maintaining the high frequency performance, such as speed and linearity. Thereby, it has to be considered that an increase of the current in one wire would result in an increased heating of the deflector, which can deteriorate the utilization in SEM inspection systems.

According to yet further embodiments, the connector 214 or the connectors 214 and 215 can be provided on a protrusion 308 of the support 230 such that the protrusion can be bended away from the optical axis when the coil unit shown in FIG. 3A is provided in a scan deflector assembly (see, e.g., FIG. 3B).

FIG. 3B shows a deflector assembly 120, wherein four of the coil units shown in FIG. 3A are combined to form two pairs of two coils or sets of coils , wherein the sets of coils can be provided by a multiple wire string. According to yet further embodiments, which can be combined with other embodiments described herein, the assembly shown in FIG. 3B can be surround by magnetically soft material. Typically, a magnetically soft material with a high electrical resistivity is used. For example, ferrite can be used.

According to yet further embodiments, which can be combined with other embodiments described herein, the rectangular-like shape of the support 230 can typically have a length along the direction of the optical axis of 4 mm to 25 mm. Typically, the length can be around 5 mm, around 10 mm or around 20 mm. The support 230 can be provided as a square or a rectangle with any of the above dimensions.

According to yet further embodiments, which can be combined with other embodiments described herein, coil units like the one shown in FIG. 3A can be formed on printed circuit boards (PCB), e.g. flexible PCBs. Thereby, the coils are not wound by wires. Rather, the wires or conductors are etched or plated on a substrate, e.g. the support. The wires or conductors can be etched in a foil to form the coil, or the two or more coils of a lamination. The PCBs can be manufactured such that a through connect 330 as shown in FIG. 3A is provided and wires or conductors can be provided on both sides. Due to the manufacturing with PCB technology, a high accuracy in manufacturing at low costs can be provided. According to alternative manufacturing methods, wires or conductors can be printed on an appropriate substrate with screen printing technology, where a conductive paste is formed on a substrate. The screenprinting also allows for through connects and double sided printing.

Within this disclosure it is referred to the terms "wire" and "conductor" in order to describe the coil-forming element. Even though at some instances only one of the terms is used, these terms are understood as equivalent in the context of a coil-forming element. Typically, a wire might be interpreted rather as a round wire, wherein a coil is wound, whereas a conductor might rather be a plated, etched, or printed conductive path, However, both terms can be replaced which other unless explicitly stated to the contrary or unless the above differences are explicitly referred to.

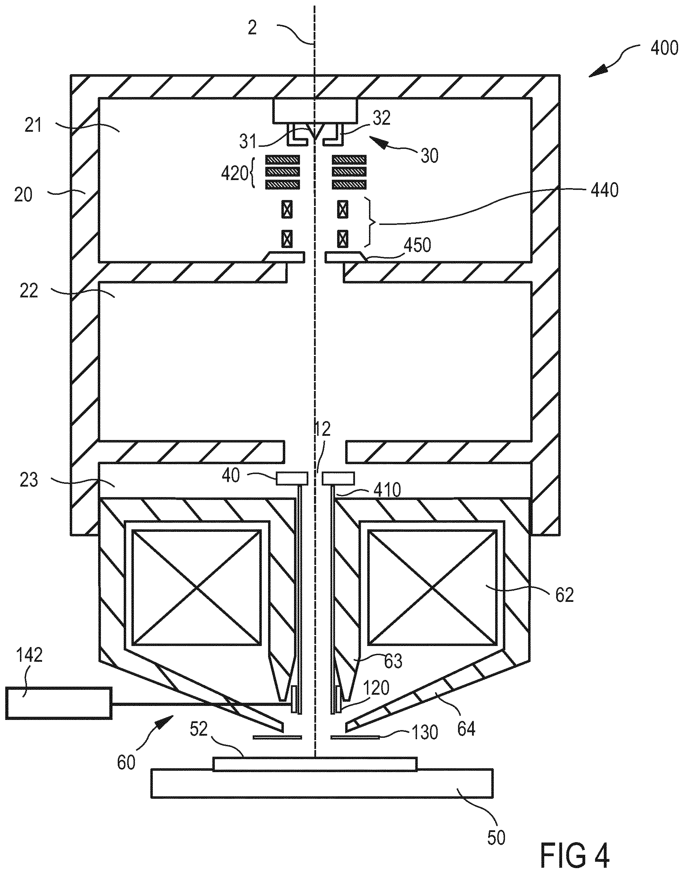

Further embodiments can be described with respect to FIG. 4. FIG. 4 shows a charged particle beam device, such as an SEM imaging apparatus, i.e. a wafer imaging system 400. The electron beam column 20 provides a first chamber 21, a second chamber 22 and a third chamber 23. The first chamber, which can also be referred to as a gun chamber, includes the electron source 30 having an emitter 31 and suppressor 32. An electron beam is generated by the electron beam source 30. The beam is aligned to the beam limiting aperture 450, which is dimensioned to shape the beam, i.e. blocks a portion of the beam. Thereafter, the beam passes through opening 12 of the detector 40 and is focused on the specimen 52. The specimen is positioned on a specimen position on the specimen stage 50. On impingement of the electron beam, for example, secondary or backscattered electrons are released from the specimen 50, which can be detected by the detector 40.

According to some embodiments, which can be combined with other embodiments described herein, a condenser lens 420 and a beam shaping or beam limiting aperture 450 is provided. The two-stage deflection system 440 is provided between the condenser lens and the beam shaping aperture 250 for alignment of the beam to the aperture.

As shown in FIG. 4, according to some embodiments, a detector 40 can be provided above the objective lens such that the primary charged particle beam passes through the opening 12 in the detector. The objective lens 60 having pole pieces 64/63 and a coil 62 focuses the charged particle beam on a specimen 52, which can be positioned on a specimen stage 50. The objective lens 60 shown in FIG. 3 includes the upper pole piece 63, the lower pole piece 64 and the coil 62 forming a magnetic lens portion of the objective lens, as well as the first (upper) electrode 110 and the second (lower) electrode 130 forming an electrostatic portion of the objective lens.

Further, a scanning deflector assembly 120 is provided. The scanning deflector assembly 120 is provided according to any of the embodiments described herein. The scanning deflector assembly is connected to controller 142.

According to typical, which can be combined with other embodiments described herein, the scanning deflector assembly 120 can be a single stage assembly as shown in FIG. 4. Alternatively also a two-stage or even a three-stage deflector assembly can be provided. Thereby, each stage is provided at a different position along the optical axis 2.

According to typical embodiments, which can be combined with other embodiments described herein, the scanning deflector assembly 120 or at least one stage of a multi-stage scanning deflector assembly can be provided as follows. The scanning deflector assembly 120 is provided within the objective lens. For example, at least a portion of the upper pole piece 63, at least a portion of the lower pole piece, and/or at least a portion of the coil 62 surrounds the scanning deflector assembly 120 or a stage of a multi-stage scanning deflector assembly.

According to yet further additional or alternative implementations, the scanning deflector assembly 120 or at least one stage of the multi-stage scanning deflector assembly can be provided surrounding the electrode 410 or between the electrode 410 and the electrode 130. Yet, further additional or alternative implementations can be provided, wherein the scanning deflector assembly 120 or at least one stage of the multi-stage scanning deflector assembly is provided between the electrode 130 and a component selected from the group consisting of: the detector and a beam separator (not shown) for separating the primary electron beam from the secondary electron (signal electron) beam.

According to a yet further embodiment, the coil system of the scanning deflector assembly 120 or of at least one stage of the multi-stage scanning deflector assembly is typically located close to the objective lens area of the SEM.

In FIG. 4 the upper electrodes 410 of the electrostatic immersion lens is provided in the form of a tube. As explained above, for an objective lens, when imaging negative charged particles, this tube is preferably on positive potential above three kV, e.g. 10 keV, 15 keV or 20 keV. Thereby, a beam boost potential is provided, i.e. the beam travels with high energy through the column. The embodiment of FIG. 4 shows a lower electrode 130 below the lower pole piece 64. The lower electrode being the deceleration electrode of the immersion lens component of the objective lens is typically at a potential (without correction) to provide a landing energy of the charged particles on the specimen of 2 keV or below, e.g. 500 V or 1 keV.

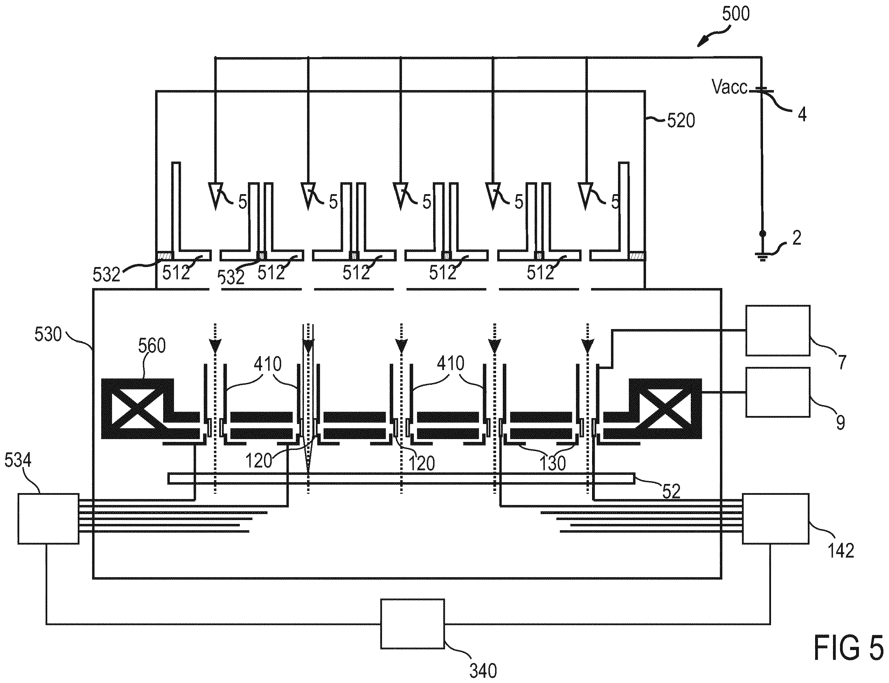

FIG. 5 illustrates yet further embodiments, wherein the retarding field scanning microscope, i.e. wafer imaging system 500 is provided as a multi-beam device. Typically two or more beams can be provided in a multi-beam device. As an example, FIG. 5 shows five emitters 5 such that 5 electron beams are emitted in the gun chamber 520. The emitter tips are biased to an acceleration potential V_{acc} by voltage supply 4, which provides a potential to the tips as compared to ground 2. Electrodes 512, e.g. suppressors, extractors, or anodes are provided, e.g. in a cup-like shape. These electrodes are electrically insulated by insulators 532 with respect to each other and with respect to the gun chamber 520. According to some embodiments, which can be combined with other embodiments described herein, also two or more of the electrodes selected from the group consisting of suppressor, extractor and anode can be provided. Typically, these electrodes 512 are biased to potentials by voltage supplies (not shown) in order to control the two or more electron beams.

The charged particle beams travel in a further chamber 530, in which a specimen 52 is provided. The objective lens 560 focuses the beams on the specimen or in a specimen plane, respectively. Thereby, the objective lens can have a common magnetic lens portion, i.e. a magnetic lens portion acting on two or more of the charged particle beams. Thereby, for example, one common excitation coil is provided to a pole piece unit or a pole piece assembly, wherein several openings for passing of the two or more electron beams through the pole piece unit are provided. The one common excitation coil excited the pole piece unit, such that for example one beam is focused per opening.

As shown in FIG. 5, the objective lens 560 further includes an electrostatic lens portion. For example, an electrostatic lens portion has a first electrode 410 and a second electrode 130. For example, the second electrodes 130 can individually be connected to a controller 534 or a respective power supply being controlled by a controller such that the potentials provided to the electrodes 130 can be synchronized with the scanning deflector of the scanning deflector assemblies 120, which act on the corresponding charged particle beams. The scanning deflector assemblies are controlled by scanning controller 142, which controls the scanning pattern of the deflectors. The controller 340 is connected to the controller/voltage supply 144 for the retarding electrodes 130 and the scan controller 142, such that synchronization can be provided.

According to some embodiments, the scan deflector assemblies 120, the scan deflectors and the coils can be provided according to any of the embodiments described herein. Thereby, it has to be considered that particularly for EBI applications, but also for CD/DR applications, as compared to common wafer imaging throughput is a critical aspect to be considered. The high scanning speed deflector assemblies and deflectors as described herein are particularly useful for high throughput. Thereby, also cold field emitters (CFE) and thermally assisted CFEs can be used to increase the throughput. Accordingly, the combination of a scanning deflector assembly 120 with a CFE or thermally assisted CFE is particularly useful, and even more, as a further implementation, in combination with a multi-electron beam device as e.g. described with respect to FIG. 5.

The embodiments described herein, may as well include additional components (not shown) such as condenser lenses, deflectors of the electrostatic, magnetic or compound electrostatic-magnetic type, such as Wien filters, stigmators of the electrostatic, magnetic or compound electrostatic-magnetic type, further lenses of the electrostatic, magnetic or compound electrostatic-magnetic type, and/or other optical components for influencing and/or correcting the beam of primary and/or secondary charged particles, such as deflectors or apertures. Indeed, for illustration purposes, some of those components are shown in the figures described herein. It is to be understood that one or more of such components can also be applied in embodiments of the invention.

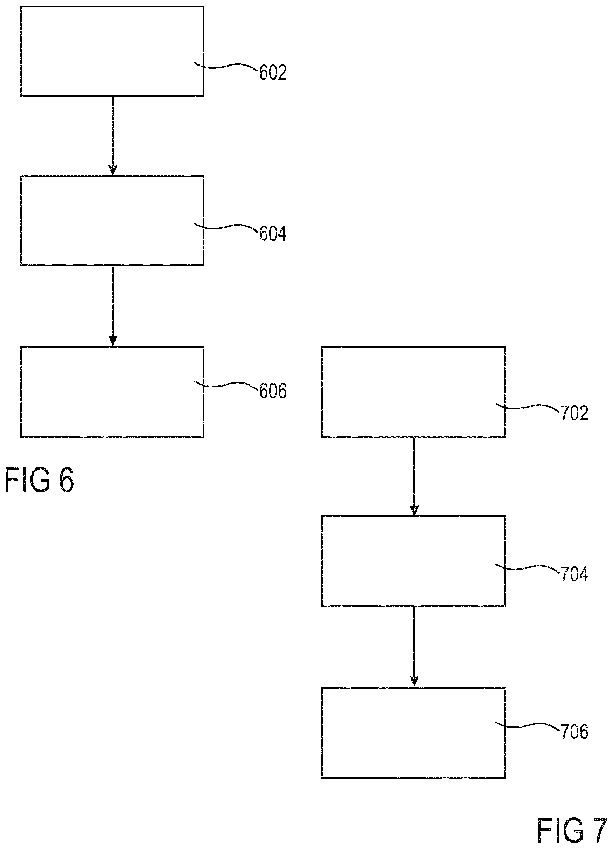

According to some embodiments, a method of imaging a specimen is provided as illustrated in FIG. 6. Thereby, particularly a retarding field scanning microscope is utilized, wherein a charged particle beam, e.g. an electron beam is used. In step 602 a charged particle beam, preferably an electron beam, is generated in the retarding field scanning microscope. In step 604 the beam is scanned over the specimen for image generation with a scanning deflector assembly according to embodiments described herein. As described above, this can be done in a high speed scanning pattern, where a pixel rate in the GHz range and/or a line rate in the MHz range are provided. The charged particle beam is focused on the specimen with a combined magnetic-electrostatic objection lens in step 606. The objective lens includes a magnetic lens portion and an electrostatic lens portion, and wherein the electrostatic lens portion includes a first electrode and a second electrode disposed between the first electrode and the specimen. Typically, the second electrode decelerates the charged particles for impingement on the specimen, i.e. an immersion lens is provided by the first and the second electrode. Accordingly, the second electrode is biased to a potential.

According to some embodiments, a method of manufacturing a magnetic deflector assembly is provided as illustrated in FIG. 7. In step 602 at least two coils wherein the number of turns in the at least two coils is 8 or less and wherein a maximum dimension of a cross-section of a coil-forming wire or of a coil forming conductor is 0.2 mm or less are provided. In step 604, a pair of coil units from the at least two coils are formed. In step 606 at least one magnetic deflector for scanning the beam over the wafer in one direction is formed from the pair of coil units. According to typical implementations, the number of coils in each coil unit can be 2 or more, e.g. wherein the 2 or more coils in each coil unit are formed by a multiple wire string or a lamination. Yet further, additionally or alternatively, the coil forming wire or coil-forming conductor can be formed by a process selected from the group consisting of: etching, patterning of a conductive foil, screen printing, masked layer deposition, and combinations thereof.

In light of the above an SEM, particularly for high throughput applications such as EBI can be provided. Thereby, magnetic scanning with high speed and improved linearity and, thus, accuracy can be provided.

While the foregoing is directed to embodiments of the invention, other and further embodiments of the invention may be devised without departing from the scope thereof, and the scope thereof is determined by the claims that follow.

## Claims

1. A magnetic deflector assembly (120) configured for scanning a primary electron beam, and particularly adapted to provide an upgrade kit for a wafer imaging system (400), the magnetic deflector assembly comprising:
at least one magnetic deflector for scanning the beam over a wafer in one direction, wherein the at least one magnetic deflector comprises at least four coils (320-1, 320-2) forming a pair of coil units (302A, 302B; 304A, 304B), wherein the number of turns (321-1, 321-2) in each of the at least four coils is 8 or less and
wherein the maximum dimension of a cross-section of a coil-forming wire or of a coil-forming conductor is 0.2 mm or less, wherein the number of coils in each coil unit is two or more, each of the two or more coils in each coil unit is formed by a multiple wire string (320-1, 320-2).

2. The system according to claim 1, wherein each wire or conductor (320-1, 320-2) of the multiple wire string of each coil unit is connected to a first connector (214) and a second connector (215) for providing current to the coils formed by the wires or conductors of the multiple wire string.

3. The magnetic deflector assembly according to any of claims 1 to 2, wherein the number of wires or conductors in each wire string is a 2 to 10.

4. The magnetic deflector assembly according to any of claims 1 to 3, wherein the scanning deflector assembly is surrounded by a magnetically soft material.

5. The magnetic deflector assembly according to claim 4, wherein the magnetically soft materials is ferrite.

6. The magnetic deflector assembly according to any of claims 1 to 5, wherein the magnetic scanning deflector assembly comprises in one stage 1 to 6 magnetic deflectors, each having a pair of coils wherein the number of turns each of the pairs of coils is 8 or less and wherein a maximum dimension of a cross-section of the coil-forming wire or of the coil-forming conductor is 0.2 mm or less.

7. The magnetic deflector assembly according to any of claims 1 to 6, wherein the coil forming wire or coil-forming conductor is formed by a process selected from the group consisting of: etching, patterning of a conductive foil, screen printing, masked layer deposition, and combinations thereof.

8. The magnetic deflector assembly according to any of claims 1 to 7, wherein the magnetic deflector is provided by at least one printed circuit board.

9. A wafer imaging system configured for imaging a wafer; comprising:
an emitter having an emitter tip adapted for providing an electron beam;
an objective lens configured for focusing the electron beam on the wafer;
at least one condenser lens provided between the emitter tip and the objective lens; and
magnetic deflector assembly (120) according to any of claims 1 to 8, for scanning the electron beam over the wafer to generate the image of the wafer.

10. The system according to claim 9, wherein magnetic deflector assembly comprises at least two stages distant from each other in direction along the optical axis.

11. The system according to any of claims 9 to 10, wherein the emitter is a cold field emitter or a thermally assisted cold field emitter.

12. The system according any of claims 9 to 11, wherein the emitter tip comprises a material selected from the group consisting of tungsten, molybdenum, tantalum, carbide such as HfC, ZrC, and any combinations thereof.

13. The system according to claim 12, wherein the emitter tip is a tungsten based W(310) crystal tip.

14. The system according to any of claims 9 to 13, wherein the magnetic deflector is provided within the objective lens.

15. Method of manufacturing a magnetic deflector assembly for scanning the electron beam over the wafer to generate the image of the wafer, comprising:
providing at least four coils wherein the number of turns in each of the at least four coils is 8 or less and wherein the maximum dimension of a cross-section of a coil-forming wire or of a coil-forming conductor is 0.2 mm or less,
forming a pair of coil units from the at least four coils,
forming at least one magnetic deflector for scanning the beam over the wafer in one direction from the pair of coil units, wherein the number of coils in each coil unit is 2 or more, each of the 2 or more coils in each coil unit is formed by a multiple wire string, and particularly wherein the coil-forming wire or coil-forming conductor is formed by a process selected from the group consisting of: etching, patterning of a conductive foil, screen printing, masked layer deposition, and combinations thereof.

## Patentansprüche

1. Magnetische Deflektorbaugruppe (120), die zum Abtasten eines Primärelektronenstrahls ausgelegt und insbesondere dazu angepasst ist, einen Aufrüstsatz für ein Wafer-Abbildungssystem (400) bereitzustellen, wobei die magnetische Deflektorbaugruppe aufweist:
mindestens einen magnetischen Deflektor, um den Strahl abtastend über einen Wafer in einer Richtung zu führen, wobei der mindestens eine magnetische Deflektor mindestens vier Spulen (320-1, 320-2) umfasst, die ein Paar Spuleneinheiten (302A, 302B; 304A, 304B) bilden, wobei die Anzahl von Wicklungen (321-1, 321-2) in jeder der mindestens vier Spulen 8 oder weniger beträgt, und
wobei die größte Abmessung eines Querschnitts eines spulenbildenden Drahts oder eines spulenbildenden Leiters 0,2 mm oder weniger beträgt, wobei die Anzahl von Spulen in jeder Spuleneinheit zwei oder mehr beträgt, wobei jede der zwei oder mehr Spulen in jeder Spuleneinheit durch einen Mehrfachdrahtstrang (320-1, 320-2) gebildet ist.

2. System nach Anspruch 1, wobei jeder Draht oder Leiter (320-1, 320-2) des Mehrfachdrahtstrangs jeder Spuleneinheit an einen ersten Verbinder (214) und einen zweiten Verbinder (215) angeschlossen ist, um Strom bereitzustellen für die Spulen, die durch die Drähte oder Leitungen des Mehrfachdrahtstrangs gebildet sind.

3. Magnetische Deflektorbaugruppe nach einem der Ansprüche 1 bis 2, wobei die Anzahl von Drähten oder Leitern in jedem Drahtstrang 2 bis 10 beträgt.

4. Magnetische Deflektorbaugruppe nach einem der Ansprüche 1 bis 3, wobei die Abtastdeflektorbaugruppe von einem magnetisch weichen Material umgeben ist.

5. Magnetische Deflektorbaugruppe nach Anspruch 4, wobei es sich bei dem magnetisch weichen Material um Ferrit handelt.

6. Magnetische Deflektorbaugruppe nach einem der Ansprüche 1 bis 5, wobei die magnetische Abtastdeflektorbaugruppe in einer Stufe 1 bis 6 magnetische Deflektoren mit jeweils einem Paar Spulen umfasst, wobei die Anzahl von Wicklungen jedes der Paare Spulen 8 oder weniger beträgt, und wobei eine größte Abmessung eines Querschnitts des spulenbildenden Drahts oder des spulenbildenden Leiters 0,2 mm oder weniger beträgt.

7. Magnetische Deflektorbaugruppe nach einem der Ansprüche 1 bis 6, wobei der spulenbildende Draht oder der spulenbildende Leiter durch einen Prozess ausgebildet ist, der aus der Gruppe ausgewählt ist, die besteht aus: Ätzen, Strukturieren einer leitfähigen Folie, Siebdrucken, Maskenschichtabscheiden und Kombinationen von diesen.

8. Magnetische Deflektorbaugruppe nach einem der Ansprüche 1 bis 7, wobei der magnetische Deflektor durch mindestens eine gedruckte Leiterplatte bereitgestellt ist.

9. Wafer-Abbildungssystem, das zum Abbilden eines Wafers ausgelegt ist, Folgendes umfassend:
einen Emitter mit einer Emitter-Spitze, die zum Bereitstellen eines Elektronenstrahls angepasst ist;
eine Objektivlinse, die dazu ausgelegt ist, den Elektronenstrahl auf den Wafer zu fokussieren;
mindestens eine Sammellinse, die zwischen der Emitter-Spitze und der Objektivlinse vorgesehen ist; und
eine magnetische Deflektorbaugruppe (120) nach einem der Ansprüche 1 bis 8, um den Elektronenstrahl abtastend über den Wafer zu führen, um das Bild des Wafers zu erzeugen.

10. System nach Anspruch 9, wobei die magnetische Deflektorbaugruppe mindestens zwei Stufen umfasst, die in einer Richtung entlang der optischen Achse voneinander entfernt sind.

11. System nach einem der Ansprüche 9 bis 10, wobei es sich bei dem Emitter um einen Kaltfeld-Emitter oder einen thermisch unterstützten Kaltfeld-Emitter handelt.

12. System nach einem der Ansprüche 9 bis 11, wobei die Emitter-Spitze ein Material umfasst, das aus der Gruppe ausgewählt ist, die aus Wolfram, Molybdän, Tantal, Carbid wie etwa HfC, ZrC, und Kombinationen von diesen besteht.

13. System nach Anspruch 12, wobei es sich bei der Emitter-Spitze um eine W(310)-Kristallspitze auf Wolframbasis handelt.

14. System nach einem der Ansprüche 9 bis 13, wobei der magnetische Deflektor innerhalb der Objektivlinse vorgesehen ist.

15. Verfahren zum Herstellen einer magnetischen Deflektorbaugruppe, um den Elektronenstrahl abtastend über einen Wafer zu führen, um das Bild des Wafers zu erzeugen, Folgendes umfassend:
Bereitstellen von mindestens vier Spulen, wobei die Anzahl von Wicklungen in jeder der mindestens vier Spulen 8 oder weniger beträgt, und wobei die größte Abmessung eines Querschnitts eines spulenbildenden Drahts oder eines spulenbildenden Leiters 0,2 mm oder weniger beträgt,
Ausbilden eines Paars Spuleneinheiten aus den mindestens vier Spulen, Ausbilden mindestens eines magnetischen Deflektors, um den Strahl abtastend über den Wafer in einer Richtung ausgehend von dem Paar Spuleneinheiten zu führen, wobei die Anzahl von Spulen in jeder Spuleneinheit 2 oder mehr beträgt, wobei jede der 2 oder mehr Spulen in jeder Spuleneinheit durch einen Mehrfachdrahtstrang gebildet wird, und
wobei insbesondere der spulenbildende Draht oder der spulenbildende Leiter durch einen Prozess ausgebildet wird, der aus der Gruppe ausgewählt ist, die besteht aus: Ätzen, Strukturieren einer leitfähigen Folie, Siebdrucken, Maskenschichtabscheiden und Kombinationen von diesen.

## Revendications

1. Ensemble déflecteur magnétique (120) configuré pour balayer un faisceau d'électrons primaires, et en particulier apte à fournir un kit de mise à niveau pour un système d'imagerie de plaquette (400), l'ensemble déflecteur magnétique comprenant :
au moins un déflecteur magnétique destiné à balayer le faisceau sur une plaquette dans une direction, sachant que l'au moins un déflecteur magnétique comprend au moins quatre bobines (320-1, 320-2) formant une paire d'unités de bobines (302A, 302B ; 304A, 304B), sachant que le nombre de tours (321-1, 321-2) dans chacune des au moins quatre bobines est de 8 ou moins et sachant que la dimension maximale d'une section transversale d'un fil formant bobine ou d'un conducteur formant bobine est de 0,2 mm ou moins, sachant que le nombre de bobines dans chaque unité de bobines est de deux ou plus, chacune des deux bobines ou plus dans chaque unité de bobines étant formée par un brin à fils multiples (320-1, 320-2).

2. Le système selon la revendication 1, sachant que chaque fil ou conducteur (320-1, 320-2) du brin à fils multiples de chaque unité de bobines est connecté à un premier connecteur (214) et un deuxième connecteur (215) destinés à fournir du courant aux bobines formées par les fils ou conducteurs du brin à fils multiples.

3. L'ensemble déflecteur magnétique selon l'une quelconque des revendications 1 à 2, sachant que le nombre de fils ou conducteurs dans chaque brin de fils est de 2 à 10.

4. L'ensemble déflecteur magnétique selon l'une quelconque des revendications 1 à 3, sachant que l'ensemble déflecteur de balayage est entouré par un matériau magnétiquement doux.

5. L'ensemble déflecteur magnétique selon la revendication 4, sachant que le matériau magnétiquement doux est de la ferrite.

6. L'ensemble déflecteur magnétique selon l'une quelconque des revendications 1 à 5, sachant que l'ensemble déflecteur de balayage magnétique comprend dans un étage 1 à 6 déflecteurs magnétiques, chacun comportant une paire de bobines, sachant que le nombre de tours de chacune de la paire de bobines est de 8 ou moins et sachant qu'une dimension maximale d'une section transversale du fil formant bobine ou du conducteur formant bobine est de 0,2 mm ou moins.

7. L'ensemble déflecteur magnétique selon l'une quelconque des revendications 1 à 6, sachant que le fil formant bobine ou le conducteur formant bobine est formé moyennant un procédé sélectionné dans le groupe constitué par : la gravure, la structuration d'une feuille conductrice, la sérigraphie, le dépôt de couche avec masque, et les combinaisons de ceux-ci.

8. L'ensemble déflecteur magnétique selon l'une quelconque des revendications 1 à 7, sachant que le déflecteur magnétique est fourni par au moins une carte de circuit imprimé.

9. Système d'imagerie de plaquette configuré pour imager une plaquette, comprenant :
un émetteur présentant une pointe d'émetteur apte à fournir un faisceau d'électrons ;
une lentille d'objectif configurée pour focaliser le faisceau d'électrons sur la plaquette ;
au moins une lentille condensatrice disposée entre la pointe d'émetteur et la lentille d'objectif ; et
un ensemble déflecteur magnétique (120) selon l'une quelconque des revendications 1 à 8, destiné à balayer le faisceau d'électrons sur la plaquette pour générer l'image de la plaquette.

10. Le système selon la revendication 9, sachant que l'ensemble déflecteur magnétique comprend au moins deux étages distants l'un de l'autre en direction le long de l'axe optique.

11. Le système selon l'une quelconque des revendications 9 à 10, sachant que l'émetteur est un émetteur à champ froid ou un émetteur à champ froid assisté thermiquement.

12. Le système selon l'une quelconque des revendications 9 à 11, sachant que la pointe d'émetteur comprend un matériau sélectionné dans le groupe constitué par le tungstène, le molybdène, le tantale, le carbure tel que HfC, ZrC, et toutes combinaisons de ceux-ci.

13. Le système selon la revendication 12, sachant que la pointe d'émetteur est une pointe de cristal W(310) à base de tungstène.

14. Le système selon l'une quelconque des revendications 9 à 13, sachant que le déflecteur magnétique est disposé à l'intérieur de la lentille d'objectif.

15. Procédé de fabrication d'un ensemble déflecteur magnétique destiné à balayer le faisceau d'électrons sur la plaquette pour générer l'image de la plaquette, comprenant :
la fourniture d'au moins quatre bobines, sachant que le nombre de tours dans chacune des au moins quatre bobines est de 8 ou moins et sachant que la dimension maximale d'une section transversale d'un fil formant bobine ou d'un conducteur formant bobine est de 0,2 mm ou moins,
la formation d'une paire d'unités de bobines à partir des au moins quatre bobines,
la formation d'au moins un déflecteur magnétique destiné à balayer le faisceau sur la plaquette dans une direction depuis la paire d'unités de bobines, sachant que le nombre de bobines dans chaque unité de bobines est de 2 ou plus, chacune des 2 bobines ou plus dans chaque unité de bobines étant formée par un brin à fils multiples, et en particulier sachant que le fil formant bobine ou le conducteur formant bobine est formé moyennant un procédé sélectionné dans le groupe constitué par : la gravure, la structuration d'une feuille conductrice, la sérigraphie, le dépôt de couche avec masque, et les combinaisons de ceux-ci.
